(19) Europäisches Patentamt
European Patent Office
Office européen des brevets

(11) **EP 3 360 170 B1**

(12) **EUROPÄISCHE PATENTSCHRIFT**

(45) Veröffentlichungstag und Bekanntmachung des Hinweises auf die Patenterteilung:
**30.10.2019 Patentblatt 2019/44**

(21) Anmeldenummer: **16770287.7**

(22) Anmeldetag: **23.09.2016**

(51) Int Cl.:
*H01L 41/047* (2006.01)    *H01L 41/107* (2006.01)

(86) Internationale Anmeldenummer:
**PCT/EP2016/072734**

(87) Internationale Veröffentlichungsnummer:
**WO 2017/060104 (13.04.2017 Gazette 2017/15)**

(54) **PIEZOELEKTRISCHER TRANSFORMATOR**

PIEZOELECTRIC TRANSFORMER

TRANSFORMATEUR PIÉZO-ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2015 DE 102015117106**

(43) Veröffentlichungstag der Anmeldung:
**15.08.2018 Patentblatt 2018/33**

(73) Patentinhaber: **TDK Electronics AG**
**81671 München (DE)**

(72) Erfinder:
• **WEILGUNI, Michael**
**4232 Hagenberg (AT)**
• **RINNER, Franz**
**8530 Deutschlandsberg (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
JP-A- 2002 217 467    KR-A- 20050 000 886
US-A- 5 504 384    US-A1- 2001 028 206

**Beschreibung**

Die Erfindung betrifft einen piezoelektrischen Transformator, umfassend ein piezoelektrisches Element mit einer vorbestimmten Längenabmessung der Länge $L$, entlang derer wenigstens eine Eingangsseite und wenigstens eine Ausgangsseite des Transformators definiert sind. An der Eingangsseite ist eine Eingangsspannung $U_{in}$ anlegbar zur Transformation in eine Ausgangsspannung $U_{out}$ an der Ausgangsseite gemäß einem Transformationsverhältnis $U_{out}/U_{in} = K_u$. Das piezoelektrische Element weist dabei mehrere Lagen von Innenelektroden auf, die in einer Richtung senkrecht zur Richtung der Längenabmessung in mehreren unterschiedlichen Schichten angeordnet sind.

Derartige piezoelektrische Transformatoren werden vielfach zur Spannungswandlung eingesetzt. Das Effizienzmaximum eines solchen piezoelektrischen Transformators wird bei einer spezifischen Resonanzfrequenz erreicht, wenn die Last an der Ausgangsseite der Impedanz der Ausgangskapazität (elektrische Kapazität zwischen einem u.U. metallisierten Bereich an der Ausgangsseite und den Innenelektroden) des piezoelektrischen Transformators entspricht. Bei einem piezoelektrischen Transformator herkömmlicher Art zeigt die Eingangsimpedanz in einem bestimmten Bereich um dieses Effizienzmaximum herum kapazitives Verhalten. Die Eingangsleistung des Transformators enthält somit in diesem Bereich einen Blindleistungsanteil.

Herkömmliche Lösungen sehen eine Serieninduktivität zur Kompensation des kapazitiven Eingangsverhaltens des piezoelektrischen Transformators in der Ansteuerung vor. Die Umladung der elektrischen Energie zwischen der Eingangskapazität (elektrische Kapazität zwischen den Lagen von Innenelektroden und dem piezoelektrischen Substrat an der Eingangsseite) des piezoelektrischen Transformators und der Serieninduktivität in der Ansteuerung erfolgt jedoch nicht verlustfrei. Zudem führt der endliche Elektrodenleitwert der Innenelektroden zu einer Erwärmung des Bauteils.

Eine andere Möglichkeit wäre, den piezoelektrischen Transformator soweit außerhalb des maximalen Effizienzbereiches zu betreiben, dass die Eingangsimpedanz rein ohmsch wird. Außerhalb des maximalen Effizienzbereiches erhöhen sich jedoch ebenfalls die Verluste im piezoelektrischen Element.

Die Dokumente KR 2005 0000886 A und JP 2002 217467 A offenbaren jeweils einen piezoelektrischen Transformator mit den Vorrichtungsmerkmalen des Oberbegriffs von Anspruch 1.

Es ist eine Aufgabe der Erfindung, den Blindleistungsanteil der Eingangsimpedanz bei einem piezoelektrischen Transformator derart zu minimieren bzw. ganz zu unterdrücken, dass elektrische Verluste im Bauteil minimiert werden und dennoch der Transformator bei maximal möglicher Effizienz betrieben werden kann.

Diese Aufgabe wird durch einen piezoelektrischen Transformator der eingangs erläuterten Art dadurch gelöst, dass durch geeignete Abmessungen der Innenelektroden die folgende Bedingung erfüllt wird:

$$C_{in} \leq N^2 C_{out} \qquad ,$$

wobei $C_{in}$ die Eingangskapazität, $C_{out}$ die Ausgangskapazität und $N$ das Transformationsverhältnis des idealen Transformators bezeichnen, nämlich dadurch, dass erfindungsgemäß sich die Lagen von Innenelektroden der ersten Gruppe von Schichten jeweils zwischen einer ersten und einer zweiten Position in einem Bereich $> 0$ und $\leq \frac{1}{2}L$ der Längenabmessung erstrecken und der jeweilige Teilabschnitt zwischen der ersten und der zweiten Position eine Länge von $\leq \frac{1}{4}L$ der Längenabmessung einnimmt.

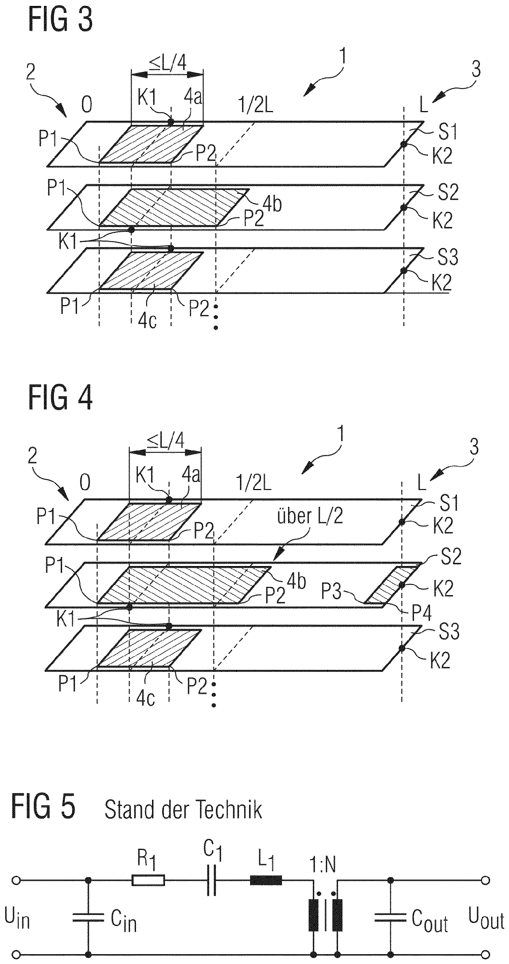

Die oben dargestellte Bedingung entspricht einer Betrachtung gemäß einem Ersatzschaltbild des piezoelektrischen Transformators. Ein solches Ersatzschaltbild ist in Figur 5 dargestellt. Dieses zeigt eine herkömmlich verwendete, schaltungstechnisch vereinfachte Beschreibung des piezoelektrischen Transformators der hier erläuterten Art. An einer Eingangsseite liegt eine Eingangsspannung $U_{in}$ an und an einer Ausgangsseite liegt eine Ausgangsspannung $U_{out}$ an. An der Eingangsseite ist die Eingangskapazität $C_{in}$ gebildet und an der Ausgangsseite ist die Ausgangskapazität $C_{out}$ gebildet. Neben den weiteren Ersatzschaltbildgrößen $R_1$, $C_1$ und $L_1$, welche die Übertragungs- und Koppeleigenschaften des piezoelektrischen Substrats beschreiben, wird eine Transformation im Ersatzschaltbild über einen idealen Transformator mit dem Transformationsverhältnis von Eingangsseite zu Ausgangsseite mit 1:N (bzw. Ausgangsseite zu Eingangsseite = N) dargestellt.

Der Vorteil eines piezoelektrischen Transformators der erläuterten Art gegenüber Transformatoren herkömmlicher Bauart besteht darin, dass die Eingangsimpedanz des Transformators unter beliebiger resistiver und kapazitiver Last jeweils bei maximal möglicher Effizienz rein ohmsch ist und keinen beziehungsweise nur einen zu vernachlässigen Blindleistungsanteil enthält. Der piezoelektrische Transformator soll Bedingung $C_{in} \leq N^2 C_{out}$ wie oben erläutert genügen. Diese Bedingung wird erfindungsgemäß dadurch erfüllt, dass durch geeignetes Elektrodendesign der Innenelektroden die Eingangskapazität des Transformators verkleinert wird, während gleichzeitig das Transformationsverhältnis weitgehend unverändert bleibt.

Durch eine unterschiedliche Dimensionierung der Teilabschnitte von Lagen von Innenelektroden einer ersten Gruppe von Schichten im Vergleich zu den Teilabschnitten von Lagen einer zweiten Gruppe von Schichten im piezoelektrischen Element kann insbesondere das proportionale Verhältnis der Eingangskapazität $C_{in}$ zur Ausgangskapazität $C_{out}$ des piezoelektrischen Transformators beeinflusst werden.

Insbesondere sind die Teilabschnitte der Lagen gemäß der ersten Gruppe von Schichten kleiner dimensioniert als die Teilabschnitte von Lagen gemäß der zweiten Gruppe von Schichten. Die Lagen aus der ersten Gruppe von Schichten beeinflussen dadurch die Eingangskapazität $C_{in}$, wobei diese verkleinert wird entsprechend der Verkleinerung der Teilabschnitte von Lagen der ersten Gruppe von Schichten gegenüber herkömmlichen Elektrodendesigns.

Nachdem die Teilabschnitte von Lagen aus der zweiten Gruppe von Schichten somit größer dimensioniert sind als die Teilabschnitte von Lagen aus der ersten Gruppe von Schichten, bestimmen die Lagen aus der zweiten Gruppe von Schichten elektrophysikalisch die Kapazität des piezoelektrischen Transformators bezüglich der Ausgangsseite, d. h. dessen Ausgangskapazität $C_{out}$. Durch geeignete Dimensionierung des Längenunterschiedes der Teilabschnitte von Lagen gemäß der zweiten Gruppe von Schichten im Verhältnis zu den Lagen der ersten Gruppe von Schichten bleibt die Ausgangskapazität $C_{out}$ somit unverändert beziehungsweise kann zusätzlich sogar erhöht werden im Vergleich zu herkömmlichen Elektrodendesigns in piezoelektrischen Transformatoren.

Kurz gesagt kann durch unterschiedliche Dimensionierung und Abmessung von Teilabschnitten von Lagen von Innenelektroden einer ersten Gruppe von Schichten im Verhältnis zu den Teilabschnitten von Lagen von Innenelektroden gemäß einer zweiten Gruppe von Schichten erzielt werden, dass die Eingangskapazität $C_{in}$ kleiner oder gleich der mit dem Quadrat des Transformationsverhältnisses N multiplizierten Ausgangskapazität $C_{out}$ ist, so dass obige Bedingung erfüllt ist. Wie bereits erläutert, kann somit eine rein ohmsche Eingangsimpedanz des piezoelektrischen Transformators erreicht werden, wobei der piezoelektrische Transformator für unterschiedliche Lasten an dessen Ausgangsseite keinen Blindleistungsanteil auf dessen Eingangsseite besitzt.

Erfindungsgemäß erstrecken sich daher die Lagen von Innenelektroden der ersten Gruppe von Schichten jeweils zwischen einer ersten und einer zweiten Position in einem Bereich $> 0$ und $\leq \frac{1}{2}L$ der Längenabmessung, wobei der jeweilige Teilabschnitt zwischen der ersten und der zweiten Position eine Länge von $\leq \frac{1}{4}L$ der Längenabmessung einnimmt. Es hat sich herausgestellt, dass bei einer derartigen Dimensionierung der Lagen von Innenelektroden der ersten Gruppe von Schichten die Eingangskapazität $C_{in}$ des piezoelektrischen Transformators klein genug dimensioniert werden kann, um die Bedingung $C_{in} \leq N^2 C_{out}$ zu erfüllen.

In einer Ausführungsform ist der piezoelektrische Transformator als ein Rosentyp-Transformator aufgebaut. Das piezoelektrische Element ist beispielsweise aus einer Blei-Zirkonat-Titanat-Keramik (PZT) aufgebaut. Die Innenelektroden sind beispielsweise aus Silber-Palladium oder Kupfer hergestellt. Bei einem in geeigneter Mehrschichtbauweise hergestellten piezoelektrischen Element können beispielsweise 50 Schichten in einer Richtung senkrecht zur Richtung der Längenabmessung des piezoelektrischen Elements geschichtet sein, wobei in bestimmten (oder allen) dieser Schichten eine entsprechende Lage von Innenelektroden aufgebaut ist. Das piezoelektrische Element ist beispielsweise derart dimensioniert, dass es eine bestimmte Längenabmessung der Länge L, eine bestimmte Breitenabmessung der Breite B und eine bestimmte Höhenabmessung der Höhe H aufweist. Dabei bezeichnet die Längenabmessung der Länge L die Hauptabmessung des piezoelektrischen Elements. Das piezoelektrische Element ist also länger als breit und länger als hoch.

Gemäß einer Ausführungsform ist das piezoelektrische Element an seiner Eingangsseite in einer Richtung senkrecht zur Richtung der Längenabmessung polarisiert und an der Ausgangsseite in Richtung der Längenabmessung polarisiert. Das bedeutet, dass der piezoelektrische Transformator an der Eingangsseite im so genannten 31-Mode (Transversal-Mode) und an der Ausgangsseite im so genannten 33-Mode (Longitudinal-Mode) betrieben wird, wobei das piezoelektrische Element bei Anlegen eines elektrischen Feldes an dessen Eingangsseite in Polarisationsrichtung eine Transversalbewegung in Richtung seiner Längenabmessung vollführt. Diese Bewegung führt zu einer Verschiebung elektrischer Ladungsträger im piezoelektrischen Element derart, dass sich in Richtung der Längenabmessung, d.h. in Longitudinalrichtung wiederum eine elektrische Spannung einstellt, die als Ausgangsspannung $U_{out}$ des Transformators an der Ausgangsseite anliegt.

In einer Ausführungsform ist die Eingangsseite des piezoelektrischen Elements im Bereich $0$ bis $\frac{1}{2}L$ der Längenabmessung eingerichtet, wobei die Ausgangsseite des piezoelektrischen Elements im Bereich $\frac{1}{2}L$ bis $L$ der Längenabmessung eingerichtet ist.

Die Erzielung der oben erläuterten vorteilhaften Eigenschaften des hier offenbarten piezoelektrischen Transformators beruht auf den Überlegungen, dass das kapazitive Verhalten eines herkömmlichen piezoelektrischen Transformators bei maximaler Effizienz darin begründet liegt, dass der Eingang des Piezo-Transformators im 31-Mode und der Ausgang im 33-Mode betrieben wird. Das bedeutet, dass die piezoelektrische Ladungskonstante $d_{31}$ an der Eingangsseite kleiner ist als die piezoelektrische Ladungskonstante $d_{33}$ an der Ausgangsseite, wobei der effektive Koppelfaktor $k_{eff,in}$ des Eingangs kleiner ist als der effektive Koppelfaktor $k_{eff,out}$ des Ausgangs. Elektrisch betrachtet bedeutet dies, dass bei piezoelektrischen Transformatoren herkömmlicher Bauart die Eingangskapazität $C_{in}$ stets größer ist als die mit dem Quadrat des Transformationsverhältnisses N multiplizierte Ausgangskapazität $C_{out}$. Anhand analytischer Betrachtung der Eigenschaften des piezoelektrischen Transformators unter Zuhilfenahme eines entsprechenden Ersatzschaltbildes kann gezeigt werden, dass die Eingangsimpedanz des Transformators kapazitiv wird, wenn bei Betrieb des Transformators die Ausgangslast $R_L$ innerhalb eines bestimmten Effizienzbereiches liegt, der mathematisch folgendermaßen beschrieben werden kann:

$$R_{L,eff}/k < R_L < R_{L,eff} \cdot k \ \texttt{mit} \ \ k = \frac{C_{in}}{C_{out}N^2}\left(1 + \sqrt{1 - \left(\frac{C_{out}N^2}{C_{in}}\right)^2}\right).$$

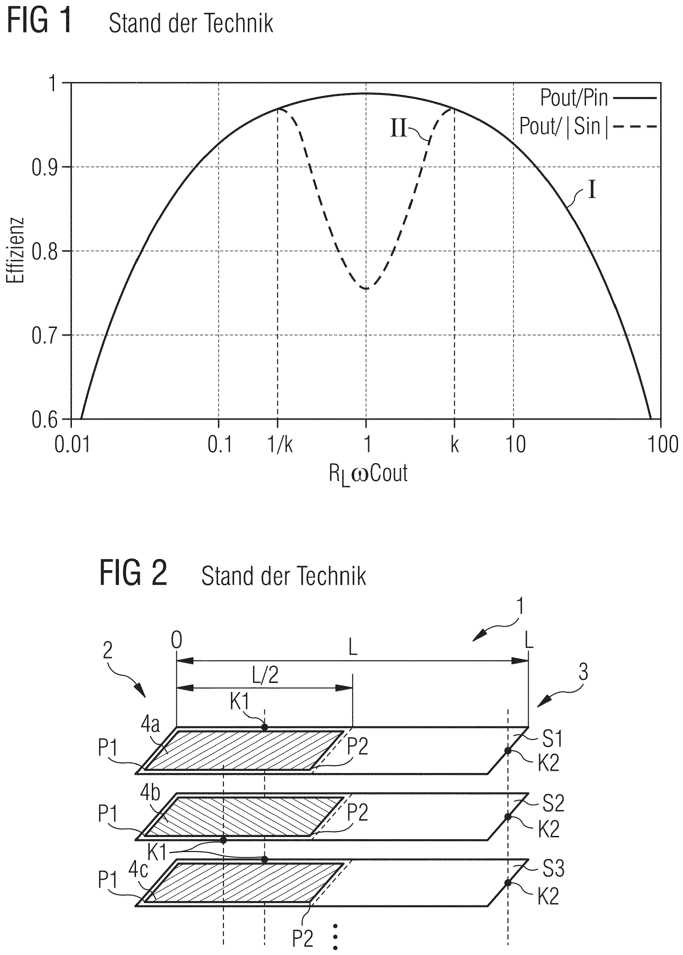

Dieses Verhalten eines herkömmlichen piezoelektrischen Transformators ist auch in Figur 1 verdeutlicht. Figur 1 zeigt zum einen eine Kennlinie I der Effizienz eines herkömmlichen piezoelektrischen Transformators, welche definiert ist als das Verhältnis der Wirkleistungen von Ausgang und Eingang $P_{out}/P_{in}$ aufgetragen über einer normierten Last ($R_L \omega C_{out}$) am Ausgang. Ferner zeigt Figur 1 eine weitere Kennlinie II, welche das Verhältnis der Ausgangswirkleistung $P_{out}$ zum Betrag der Eingangsscheinleistung $S_{in}$ wiedergibt. Aus Figur 1 ist erkennbar, dass die Kennlinie II in dem Bereich $1/k < R_L \omega C_{out} < k$ von zwei Randextremstellen (siehe senkrechte Markierungen) auf ein lokales Minimum bei $R_L \omega C_{out} = 1$ abfällt. In dem dargestellten Bereich hat die Eingangsimpedanz eines herkömmlichen piezoelektrischen Transformators einen kapazitiven Anteil, welcher eine Blindleistung bedingt. Somit sinkt das Verhältnis der Ausgangswirkleistung $P_{out}$ zum Betrag der Eingangsscheinleistung $S_{in}$ aufgrund des Blindleistungsanteils symmetrisch zu $R_L \omega C_{out} = 1$ hin ab. An diesem Punkt ist die Blindleistung aufgrund eines maximal kapazitiven Verhaltens der Eingangsimpedanz am größten, sodass die Effizienz der Wirkleistungen $P_{out}/P_{in}$ hier am geringsten ist.

Die vorliegende Erfindung macht sich nun die Erkenntnis zu Nutzen, dass das Verhältnis $C_{in} \leq N^2 C_{out}$ in erster Näherung vom Verhältnis der piezoelektrischen Ladungskonstanten $d_{33}/d_{31}$ abhängt. Durch geeignetes Elektrodendesign kann erreicht werden, dass die Eingangskapazität derart verringert wird, dass bei Erreichen der Bedingung $C_{in} = N^2 C_{out}$ in oben ausgeführter analytischer Beschreibung des Bereiches, welcher auch in Figur 1 veranschaulicht ist, der Ausdruck für k zu k=1 wird. Das bedeutet, dass unter der Bedingung $C_{in} \leq N^2 C_{out}$ der in Figur 1 dargestellte Bereich verschwindet. Unter der genannten Bedingung ist die Eingangsimpedanz eines piezoelektrischen Transformators somit rein ohmsch bei maximaler Effizienz und enthält keinerlei kapazitiven Anteil, welcher wiederum eine Blindleistung der Eingangsleistung hervorrufen würde. Ferner ist die piezoelektrische Ladungskonstante $d_{31}$ an der Eingangsseite unter dieser Bedingung größer als die piezoelektrische Ladungskonstante $d_{33}$ an der Ausgangsseite. Dies bedeutet, dass auch der effektive Koppelfaktor $k_{eff,in}$ an der Eingangsseite größer ist als der effektive Koppelfaktor $k_{eff,out}$ an der Ausgangsseite.

Aufgrund dieser Erkenntnis und der bereits erläuterten unterschiedlichen Dimensionierung der Innenelektroden in unterschiedlichen Schichten des piezoelektrischen Elements kann die Eingangsimpedanz unter beliebiger resistiver oder kapazitiver Last am Ausgang des Transformators jeweils bei maximaler Effizienz rein ohmsch dimensioniert werden, so dass sie keinen Blindleistungsanteil enthält. Ein Vorteil liegt darin, dass bei der Ansteuerung auf eine herkömmliche Serieninduktivität verzichtet werden kann und somit die Gesamteffizienz des Systems aus piezoelektrischem Transformator und Ansteuerungsschaltung gesteigert werden kann. Ein weiterer Vorteil ist, dass eine Regelung auf maximale Effizienz bei beliebiger Last am Ausgang einfach zu realisieren ist. Aufgrund der rein ohmschen Eingangsimpedanz beträgt der Phasenwinkel der Eingangsimpedanz bei maximaler Effizienz stets $\varphi = 0°$, so dass die Zeitverläufe von Eingangsstrom und Eingangsspannung stets in Einklang sind. Auf diese Weise kann eine Regelung des piezoelektrischen Transformators einfach gehalten werden, wobei lediglich eine Frequenzregelung derart durchzuführen ist, dass die Effizient $P_{out}/P_{in}$ bei einer entsprechend am Ausgang anliegenden Last auf ein Maximum geregelt wird. Idealerweise liegt das Effizienzmaximum bei der Resonanzfrequenz des piezoelektrischen Elements, wenn die Ausgangslast der Impedanz der Ausgangskapazität $C_{out}$ des piezoelektrischen Transformators entspricht.

Ein Beispiel für eine Regelung des piezoelektrischen Transformators ist die Anwendung eines solchen zum Generieren eines nicht-thermischen Atmosphärendruckplasmas. In diesem Fall ist die als nicht-induktiv, d.h. resistiv und/oder kapazitiv, zu betrachtende Last am Ausgang des piezoelektrischen Transformators eine Funktion des Plasmas. Da das Plasma wiederum von den Eigenschaften der Atmosphäre beziehungsweise des verwendeten Arbeitsgases abhängt, ist die durch das Plasma wirkende Last in der Regel variabel. Zwar kann sich eine solche variable Last auf einen Phasenversatz der Zeitverläufe von Eingangsstrom und Eingangsspannung am Transformator auswirken, allerdings kann die Frequenz relativ einfach nachgeregelt werden, so dass der Phasenversatz $\varphi = 0°$ wird. Somit kann eine Regelung auf ein Effizienzmaximum einfach gestaltet werden.

Vorteilhaft erfolgt eine Ansteuerung des piezoelektrischen Transformators der hier vorliegenden Art über ein sinusförmiges Eingangsspannungssignal. Das sinusförmige Eingangsspannungssignal kann beispielsweise durch ein hochfrequentes pulsweitenmoduliertes (PWM-) Schaltsignal erzeugt werden.

In einer Ausführungsform des piezoelektrischen Transformators der erläuterten Art wechseln sich Schichten der ersten Gruppe mit Schichten der zweiten Gruppe ab. Das bedeutet, dass sich jeweils eine Schicht mit einer Lage von Innenelektroden gemäß einer ersten Konfiguration bezüglich der Längenabmessung mit einer Schicht aufweisend eine Lage von Innenelektroden gemäß einer zweiten Konfiguration bezüglich der Längenabmessung in Richtung des Schichtaufbaus am piezoelektrischen Element abwechselt. Auf diese Weise ist eine homogene Verteilung der Lagen von Innenelektroden mit unterschiedlichen Dimensionierungen entlang des Schichtaufbaus des piezoelektrischen Elements erzielbar.

In einer Ausführungsform des piezoelektrischen Transformators erstrecken sich die Lagen von Innenelektroden der ersten Gruppe von Schichten jeweils zwischen der ersten und der zweiten Position symmetrisch um die Position bei $\frac{1}{4}L$ der Längenabmessung herum. Eine derartige Anordnung der Lagen von Innenelektroden symmetrisch um die Position bei $\frac{1}{4}L$ der Längenabmessung hat elektromechanische Gründe. Bei einem Betrieb des piezoelektrischen Transformators mit einem periodischen Eingangsspannungssignal kann der Transformator zu Transversalschwingungen der zweiten harmonischen Oberschwingung bezüglich einer Grundfrequenz angeregt werden. Dabei stellen sich entlang des piezoelektrischen Elements zwei Knotenpunkte bei $\frac{1}{4}L$ und $\frac{3}{4}L$ der Längenabmessung ein. An diesen Positionen tritt somit keine (oder nur eine vernachlässigbare) mechanische Verformungsarbeit am piezoelektrischen Element auf. Ferner ist die Einkoppelwirkung der elektrischen Energie in das piezoelektrische Element an diesen Punkten optimal. Betrachtet man die Eingangsseite des piezoelektrischen Elements in einem Bereich 0 bis $\leq \frac{1}{2}L$ der Längenabmessung, so stellt die Position bei $\frac{1}{4}L$ der Längenabmessung einen optimalen Symmetriepunkt zur Ausbildung der Lagen von Innenelektroden der ersten Gruppe von Schichten dar.

In einer Ausführungsform des piezoelektrischen Transformators erstrecken sich die Lagen von Innenelektroden der zweiten Gruppe von Schichten jeweils zwischen einer ersten und einer zweiten Position in einem Bereich > 0 und $\leq \frac{1}{2}L$ der Längenabmessung, wobei der jeweilige Teilabschnitt zwischen der ersten und der zweiten Position eine Länge von > $\frac{1}{4}L$ und < $\frac{1}{2}L$ der Längenabmessung einnimmt. Eine derartige Konfiguration der Lagen von Innenelektroden der zweiten Gruppe von Schichten hat den Vorteil, dass die Ausgangskapazität $C_{out}$ nicht verkleinert wird. In Zusammenspiel mit der Konfiguration der Lagen von Innenelektroden der ersten Gruppe von Schichten, wie oben erläutert, kann somit die Bedingung $C_{in} \leq N^2 C_{out}$ sehr gut erzielt werden.

Ergänzend hierzu können sich die Lagen von Innenelektroden der zweiten Gruppe von Schichten in einer Ausführungsform auch jeweils zusätzlich in einem Teilabschnitt zwischen einer dritten und einer vierten Position in einem Bereich $\geq \frac{7}{8}L$ und $\leq L$ der Längenabmessung erstrecken.

In einer alternativen Ausführungsform erstrecken sich die Lagen von Innenelektroden der zweiten Gruppe von Schichten jeweils zwischen einer ersten und einer zweiten Position in einem Bereich > 0 und $\leq \frac{3}{4}L$ der Längenabmessung, wobei der jeweilige Teilabschnitt zwischen der ersten und der zweiten Position eine Länge von $\geq \frac{3}{8}L$ und < $\frac{3}{4}L$ der Längenabmessung einnimmt.

Durch die alternativen Ausführungsformen der letztgenannten Art kann die Ausgangskapazität $C_{out}$ vergrößert werden, wodurch die Bedingung $C_{in} \leq N^2 C_{out}$ ebenfalls erfüllt werden kann.

Nachfolgend wird die Erfindung anhand mehrerer Zeichnungen näher erläutert.

Es zeigen:

Figur 1 Leistungskennlinien über einer normierten Last an der Ausgangsseite eines piezoelektrischen Transformators nach dem Stand der Technik,

Figur 2 eine schematisierte Darstellung eines teilweisen Schichtaufbaus eines piezoelektrischen Transformators nach dem Stand der Technik,

Figur 3 eine schematisierte Darstellung eines teilweisen Schichtaufbaus eines piezoelektrischen Transformators gemäß einer Ausführungsform der Erfindung,

Figur 4 eine schematisierte Darstellung eines teilweisen Schichtaufbaus eines piezoelektrischen Transformators gemäß einer zweiten Ausführungsform der Erfindung und

Figur 5 ein herkömmlich angewendetes Ersatzschaltbild eines piezoelektrischen Transformators.

Figur 1 wurde bereits oben ausführlich diskutiert, ebenso das Ersatzschaltbild eines piezoelektrischen Transformators gemäß Figur 5.

Figur 2 zeigt eine schematisierte Darstellung eines teilweisen Schichtaufbaus eines piezoelektrischen Transformators nach dem Stand der Technik. Der Transformator umfasst ein piezoelektrisches Element 1 mit einer vorbestimmten Längenabmessung der Länge L, welche von der linken Seite (Länge=0) zur rechten Seite (Länge=L) definiert ist. Das piezoelektrische Element 1 weist eine Eingangsseite 2 sowie eine Ausgangsseite 3 auf. Das äußere Ende der Ausgangsseite 3 kann beispielsweise metallisiert sein und eine Ausgangselektrode bilden. Die Eingangsseite 2 erstreckt sich auf der linken Seite des piezoelektrischen Elements 1 in einem Bereich 0 bis $\frac{1}{2}L$ der Längenabmessung. Die Ausgangsseite 3 erstreckt sich auf der rechten Seite des piezoelektrischen Elements 1 in einem Bereich $\frac{1}{2}L$ bis $L$ der Längenabmessung.

Das piezoelektrische Element 1 ist in Mehrschichtbauweise ausgeführt, wobei in Figur 2 mehrere Schichten S1, S2 und S3 dargestellt sind, die in einer Richtung senkrecht zur Richtung der Längenabmessung aufgebaut sind. Zur verbesserten Veranschaulichung sind die Schichten S1 bis S3 getrennt voneinander dargestellt, jedoch im gefertigten Bauteil in Schichtrichtung übereinander gestapelt und zur Bildung des piezoelektrischen Elements 1 formverbunden. Dies kann je nach Herstellungsverfahren beispielsweise in einem speziellen Sinterprozess erfolgen. Das piezoelektrische Element 1 ist beispielsweise aus einer PZT-Verbindung aufgebaut.

Auf einer jeden Schicht S1 bis S3 ist jeweils eine Lage 4a, 4b und 4c von Innenelektroden aufgebracht, die sich zwischen einer ersten Position P1 und einer zweiten Position P2 in einem Bereich > 0 bis < ½$L$ auf der Eingangsseite 2 des piezoelektrischen Elementes 1 erstrecken. Die Lagen 4a, 4b und 4c von Innenelektroden können über seitliche Außenkontaktierungen K1, welche seitlich alternierend an der Außenseite des piezoelektrischen Elements 1 angeordnet sind, mit einer eingangsseitigen Spannungsversorgung elektrisch verbunden werden. Auf diese Weise kann an die Lagen 4a bis 4c von Innenelektroden eine elektrische Spannung angelegt werden, so dass das piezoelektrische Element 1 und damit der piezoelektrische Transformator betrieben werden können. Im Betrieb wird das piezoelektrische Element 1 vermittels einer eingangsseitigen sinusförmigen Wechselspannung $U_{in}$ zu Schwingungen angeregt, wodurch sich entlang der Längenabmessung eine Transversalwelle ausbildet. Aufgrund dessen wird an der Ausgangsseite 3 des piezoelektrischen Elements 1 eine elektrische Ausgangsspannung $U_{out}$ gebildet, wobei die Eingangsspannung $U_{in}$ in die Ausgangsspannung $U_{out}$ gemäß einem vorbestimmten Transformationsverhältnis $U_{out}/U_{in} = K_u$ gewandelt wird. Die Ausgangsspannung $U_{out}$ kann über zweite Außenkontaktierungen K2 an der Ausgangsseite 3 des piezoelektrischen Elements 1 abgegriffen werden oder eine bestimmte sonstige Funktionalität erfüllen. Beispielsweise kann das piezoelektrische Element 1 dazu verwendet werden, als piezoelektrischer Transformator zur Zündung eines nicht-thermischen Atmosphärendruck-Plasmas zur Plasmaerzeugung eingesetzt zu werden. Aufgrund einer sehr hohen Ausgangsspannung $U_{out}$ an der Ausgangsseite 3 des piezoelektrischen Elementes 1 kann somit ein nichtthermisches Plasma unter Atmosphärendruck erzeugt werden.

Aufgrund von hohen elektrischen Feldstärken an der Ausgangsseite 3 kann ein bestimmtes Arbeitsgas ionisiert werden, so dass ein Arbeitsgas-Plasma entsteht.

Der piezoelektrische Transformator gemäß dem in Figur 2 gezeigten teilweisen Schichtaufbau stellt einen herkömmlichen Aufbau dar. Sein Betriebsverhalten entspricht im Wesentlichen den Leistungskennlinien I und II gemäß Figur 1, deren Eigenschaften weiter oben bereits ausgeführt worden sind und auf die an dieser Stelle verwiesen wird. Der piezoelektrische Transformator gemäß Figur 2 hat den Nachteil, dass in einem charakteristischen Bereich der normierten Ausgangslast gemäß Figur 1 die Eingangsimpedanz an der Eingangsseite 2 kapazitives Verhalten aufweist. Auf diese Weise entsteht an der Eingangsseite ein Blindleistungsanteil, der sich als Verlustleistung niederschlägt.

Figur 3 zeigt eine schematisierte Darstellung eines teilweisen Schichtaufbaus eines piezoelektrischen Transformators gemäß einer ersten Ausführungsform der Erfindung mit verbesserten Eigenschaften gegenüber dem piezoelektrischen Transformator nach Figur 2. Auch bei dem Transformator gemäß Figur 3 sind beispielhaft drei Schichten S1 bis S3 eines piezoelektrischen Elements 1 mit entsprechend aufgebrachten Lagen 4a bis 4c von Innenelektroden dargestellt. In Figur 3 sind die Innenelektroden ebenfalls an der Eingangsseite 2 des piezoelektrischen Elements 1 angeordnet.

Im Unterschied zum Aufbau gemäß Figur 2 umfasst das piezoelektrische Element 1 zwei Gruppen von Schichten, die sich in der Abmessung der Teilabschnitte von Lagen von Innenelektroden hinsichtlich der Längenabmessung unterscheiden und die abwechselnd in Richtung des Schichtaufbaus angeordnet sind. Bei einer ersten Gruppe von Schichten S1 und S3 sind die Teilabschnitte der Lagen 4a und 4c von Innenelektroden entlang der Längenabmessung kürzer dimensioniert als bei einer zweiten Gruppe von Schichten, repräsentiert durch die Schicht S2, bei der der Teilabschnitt der dargestellten Lage 4b der Innenelektrode hinsichtlich der Längenabmessung länger dimensioniert ist. Natürlich ist Figur 3 lediglich ein Ausschnitt des Schichtaufbaus. Es gibt neben der dargestellten Schicht S2 mit der Lage 4b noch weitere Schichten S2 mit entsprechenden Lagen 4b.

Dadurch, dass die Teilabschnitte der Lagen 4a und 4c der ersten Gruppe von Schichten S1 und S3 und die Teilabschnitte von Lagen 4b der zweiten Gruppe von Schichten S2 unterschiedliche Abmessungen aufweisen, genügt der piezoelektrische Transformator gemäß Figur 3 der Bedingung $C_{in} \leq N^2 C_{out}$, wobei $C_{in}$ die Eingangskapazität, $C_{out}$ die Ausgangskapazität und N das Transformationsverhältnis zwischen Ausgangsseite und Eingangsseite des idealen Transformators gemäß einer Betrachtung des Ersatzschaltbildes aus Figur 5 bezeichnen. Der Transformator gemäß Figur 3 hat den Vorteil gegenüber dem herkömmlichen Transformator von Fig. 2, dass die Eingangsimpedanz aufgrund der genannten Bedingung rein ohmsch ist und keinerlei bzw. nur vernachlässigbar kleine kapazitive Anteile aufweist. Auf diese Weise ist die Eingangsleistung an der Eingangsseite 2 des Transformators reell und weist keinerlei Blindleistungsanteil auf. Somit sind auch die Zeitverläufe einer periodischen Eingangsspannung und eines periodischen Eingangsstroms in Phase, so dass der Phasenversatz bei maximaler Effizienz stets $\varphi = 0°$ beträgt. Der piezoelektrische Transformator gemäß Figur 3 ist daher besonders verlustarm und erfordert keinerlei zusätzliche Bauelemente, wie z. B. eine herkömmliche Serieninduktivität in der Ansteuerschaltung.

Ferner ist die Ansteuerung des piezoelektrischen Transformators gemäß Figur 3 sehr einfach zu gestalten, da lediglich auf ein Effizienzmaximum in Abhängigkeit von einer an der Ausgangsseite 3 befindlichen Last geregelt werden

6

muss, ohne einen lastabhängigen Phasenversatz zwischen Eingangsspannung und Eingangsstrom an der Eingangsseite 2 des Transformators berücksichtigen zu müssen. Eine ausgangsseitige Last kann beispielsweise derart variabel gestaltet sein, dass der Transformator zur Plasma-Erzeugung verwendet wird, wobei das Plasma hinsichtlich des verwendeten Arbeitsgases beziehungsweise der vorliegenden Atmosphäre variable Eigenschaften hat.

Konkret sind in der Ausführungsform gemäß Figur 3 die Lagen 4a und 4c der Innenelektroden gemäß den Schichten S1 und S3 derart dimensioniert, dass sie sich zwischen einer ersten Position P1 und einer zweiten Position P2 symmetrisch um die Position bei ¼$L$ der Längenabmessung herum erstrecken und erfindungsgemäß einen Teilabschnitt mit einer Länge ¼$L$ einnehmen. Das bedeutet, dass die erste Position P1 bei ⅛$L$ befindlich ist, während die Position P2 bei ⅜$L$ befindlich ist. Aufgrund dieser Dimensionierung der Länge der Innenelektroden in den Schichten S1 und S3 kann die Eingangskapazität $C_{in}$ des piezoelektrischen Transformators relativ klein dimensioniert werden. In jedem Fall sind die Lagen 4a und 4c der Innenelektroden in den Schichten S1 und S3 gemäß Figur 3 deutlich kleiner dimensioniert als die Lagen 4a und 4c der Innenelektroden der Schichten S1 und S3 in einem Transformator gemäß Figur 2.

Ferner hat die Einrichtung der Lagen 4a und 4c der Innenelektroden in den Schichten S1 und S3 symmetrisch um die Position bei ¼$L$ herum den Vorteil, dass bei einem Betrieb des Transformators in einer Oberschwingung mit Knotenpunkten bei ¼$L$ und ¾$L$ die mechanische Belastung bei ¼$L$ minimal ist und gleichzeitig an dieser Position hervorragende Einkoppeleigenschaften zum Einkoppeln der elektrischen Energie in das piezoelektrische Element 1 vorliegen.

Weiterhin ist die Lage 4b der Innenelektrode der Schicht S2 in Figur 3 derart dimensioniert, dass sie sich zwischen einer ersten Position P1 bei ⅛$L$ und einer zweiten Position P2 bei ½$L$ erstreckt. Somit nimmt die Innenelektrode der Schicht S2 einen Teilabschnitt mit einer Länge von ⅜$L$ ein. Aufgrund einer derartigen Dimensionierung verhält sich die Ausgangskapazität $C_{out}$ des piezoelektrischen Transformators gemäß Figur 3 im Wesentlichen wie die Ausgangskapazität $C_{out}$ des Transformators gemäß Figur 2. Aufgrund der Dimensionierung der Lagen 4a, 4b und 4c der Innenelektroden in den Schichten S1, S2 und S3 gemäß Figur 3 kann somit erreicht werden, dass der Transformator der Bedingung $C_{in} \leq N^2 C_{out}$ genügt.

Figur 4 zeigt eine schematisierte Darstellung eines teilweisen Schichtaufbaus eines piezoelektrischen Transformators gemäß einer zweiten Ausführungsform der Erfindung. Der Schichtaufbau unterscheidet sich vom Schichtaufbau aus Figur 3 einerseits dadurch, dass die Lage 4b der Innenelektrode in Schicht S2 einen ersten Teilabschnitt zwischen einer ersten Position P1 und einer zweiten Position P2 einnimmt, wobei die erste Position P1 bei ⅛$L$ angeordnet ist und die Position P2 in einem Bereich > ½$L$ angeordnet ist, so dass die Innenelektrode nach rechts über ½$L$ hinausragt. Beispielsweise nimmt die Innenelektrode der Lage 4b einen Teilabschnitt der Länge ≥ ⅜$L$ und < ¾$L$ ein.

Der Schichtaufbau gemäß Figur 4 unterscheidet sich vom Schichtaufbau aus Figur 3 andererseits dadurch, dass sich die Innenelektrode der Lage 4b in Schicht S2 in einem zweiten Teilabschnitt zwischen einer dritten Position P3 und einer vierten Position P4 in einem Bereich ≥ ⅞$L$ und ≤ $L$ erstreckt. Aufgrund der Einrichtung einer zusätzlichen Elektrodenfläche an der Ausgangsseite 3 der Schicht S2 kann die Ausgangskapazität $C_{out}$ des Transformators vergrößert werden, wodurch die Bedingung $C_{in} \leq N^2 C_{out}$ ebenfalls erfüllt werden kann.

Es ist auch denkbar, die Ausführungsformen gemäß Figur 3 und Figur 4 zu kombinieren, wobei die Lage 4b von Innenelektroden der Schicht S2 linksseitig entsprechend der Ausführung in Figur 3 dimensioniert sein kann und rechtsseitig an der Ausgangsseite 3 einen zusätzlichen Teilabschnitt gemäß der Ausführung in Figur 4 aufweisen kann. Andere Dimensionierungen innerhalb der allgemein angegebenen Bereiche der oben erläuterten Art sind natürlich ebenso denkbar.

Generell ist auch denkbar, das Elektrodendesign und/oder auch die Aufteilung der Schichten S1, S2, S3 mit entsprechenden Lagen 4a, 4b, 4c in Schichtrichtung abzuwandeln. Hierbei ist auch denkbar, Zwischenschichten einzuführen, die keine Lagen von Innenelektroden aufweisen. Entscheidend ist, dass Teilabschnitte von Lagen einer ersten Gruppe von Schichten und Teilabschnitte von Lagen einer zweiten Gruppe von Schichten unterschiedliche Abmessungen hinsichtlich der Längenabmessung des piezoelektrischen Elements 1 aufweisen, um der mehrfach erläuterten Bedingung des Verhältnisses der Eingangskapazität $C_{in}$ zur Ausgangskapazität $C_{out}$ zu genügen, und dass erfindunggemäß die erste Gruppe von Schichten die Abmessungen nach Anspruch 1 aufweist. Beispielsweise kann die Lage 4b der Innenelektrode aus Schicht S2 gemäß Figur 3 eine Länge zwischen ⅜$L$ und ½$L$ der Längenabmessung einnehmen. Generell sind vielerlei Kombinationsmöglichkeiten, Ausgestaltungen, aber auch Abwandlungen der Ausführungsformen gemäß Figur 3 und Figur 4 denkbar.

Die dargestellten Ausführungsformen sind lediglich beispielhaft gewählt.

Bezugszeichenliste

1          piezoelektrisches Element

| 2 | Eingangsseite |
|---|---|
| 3 | Ausgangsseite |
| 4a, 4b, 4c | Lagen von Innenelektroden |
| K1, K2 | Außenkontaktierungen |
| L | Länge |
| P1 | erste Position eines Teilabschnitts |
| P2 | zweite Position eines Teilabschnitts |
| P3 | dritte Position eines Teilabschnitts |
| P4 | vierte Position eines Teilabschnitts |
| S1, S2, S3 | Schichten |

**Patentansprüche**

1. Piezoelektrischer Transformator umfassend ein piezoelektrisches Element (1) mit einer vorbestimmten Längenabmessung der Länge *L,* entlang derer wenigstens eine Eingangsseite (2) und wenigstens eine Ausgangsseite (3) des Transformators definiert sind, wobei an der Eingangsseite (2) eine Eingangsspannung $U_{in}$ anlegbar ist zur Transformation in eine Ausgangsspannung $U_{out}$ an der Ausgangsseite (3) gemäß einem Transformationsverhältnis $Uout/U_{in} = K_u$, und wobei das piezoelektrische Element (1) mehrere Lagen (4a, 4b, 4c) von Innenelektroden aufweist, die in einer Richtung senkrecht zur Richtung der Längenabmessung in mehreren unterschiedlichen Schichten (S1, S2, S3) angeordnet sind,
wobei
sich eine jede Lage (4a, 4b, 4c) von Innenelektroden entlang zumindest eines vorbestimmten Teilabschnitts der Längenabmessung erstreckt und wobei die Teilabschnitte von Lagen (4a, 4c) einer ersten Gruppe von Schichten (S1, S3) und die Teilabschnitte von Lagen (4b) einer zweiten Gruppe von Schichten (S2) unterschiedliche Abmessungen aufweisen, so dass der piezoelektrische Transformator der folgenden Bedingung genügt:

$$C_{in} \leq N^2 C_{out} \qquad ,$$

wobei $C_{in}$ die Eingangskapazität, $C_{out}$ die Ausgangskapazität und N das Transformationsverhältnis des idealen Transformators bezeichnen, **dadurch gekennzeichnet, dass** sich die Lagen (4a, 4c) von Innenelektroden der ersten Gruppe von Schichten (S1, S3) jeweils zwischen einer ersten und einer zweiten Position (P1, P2) in einem Bereich >0 und $\leq \frac{1}{2}L$ der Längenabmessung erstrecken und der jeweilige Teilabschnitt zwischen der ersten und der zweiten Position (P1, P2) eine Länge von $\leq \frac{1}{4}L$ der Längenabmessung einnimmt.

2. Piezoelektrischer Transformator nach Anspruch 1, wobei sich Schichten (S1, S3) der ersten Gruppe mit Schichten (S2) der zweiten Gruppe abwechseln.

3. Piezoelektrischer Transformator nach Anspruch 1 oder 2, wobei sich die Lagen (4a, 4c) von Innenelektroden der ersten Gruppe von Schichten (S1, S3) jeweils zwischen der ersten und der zweiten Position (P1, P2) symmetrisch um die Position bei $\frac{1}{4}L$ der Längenabmessung herum erstrecken.

4. Piezoelektrischer Transformator nach einem der Ansprüche 1 bis 3, wobei sich die Lagen (4b) von Innenelektroden der zweiten Gruppe von Schichten (S2) jeweils zwischen einer ersten und einer zweiten Position (P1, P2) in einem Bereich > 0 und $\leq \frac{1}{2}L$ der Längenabmessung erstrecken und der jeweilige Teilabschnitt zwischen der ersten und der zweiten Position (P1, P2) eine Länge von > $\frac{1}{4}L$ und < $\frac{1}{2}L$ der Längenabmessung einnimmt.

5. Piezoelektrischer Transformator nach einem der Ansprüche 1 bis 3, wobei sich die Lagen (4b) von Innenelektroden der zweiten Gruppe von Schichten (S2) jeweils zwischen einer ersten und einer zweiten Position (P1, P2) in einem Bereich > 0 und $\leq \frac{3}{4}L$ der Längenabmessung erstrecken und der jeweilige Teilabschnitt zwischen der ersten und der zweiten Position (P1, P2) eine Länge von $\geq \frac{3}{8}L$ und < $\frac{3}{4}L$ der Längenabmessung einnimmt.

6. Piezoelektrischer Transformator nach Anspruch 4 oder 5, wobei sich die Lagen (4b) von Innenelektroden der zweiten Gruppe von Schichten (S2) jeweils zusätzlich in einem Teilabschnitt zwischen einer dritten und einer vierten Position (P3, P4) in einem Bereich $\geq \frac{7}{8}L$ und $\leq L$ der Längenabmessung erstrecken.

7. Piezoelektrischer Transformator nach einem der Ansprüche 4 bis 6, wobei bezüglich der Längenabmessung die erste Position (P1) der Lagen (4b) von Innenelektroden der zweiten Gruppe von Schichten (S2) der ersten Position (P1) der Lagen (4a, 4c) von Innenelektroden der ersten Gruppe von Schichten (S1, S3) entspricht.

8. Piezoelektrischer Transformator nach einem der Ansprüche 1 bis 7, wobei das piezoelektrische Element (1) an der Eingangsseite (2) in einer Richtung senkrecht zur Richtung der Längenabmessung polarisiert ist und an der Ausgangsseite (3) in Richtung der Längenabmessung polarisiert ist.

9. Piezoelektrischer Transformator nach einem der Ansprüche 1 bis 8, wobei die Eingangsseite (2) im Bereich 0 bis ½*L* der Längenabmessung des piezoelektrischen Elements (1) eingerichtet ist und die Ausgangsseite (3) im Bereich ½*L* bis *L* der Längenabmessung des piezoelektrischen Elements (1) eingerichtet ist.

**Claims**

1. Piezoelectric transformer comprising a piezoelectric element (1) with a predetermined length dimension of the length L along which at least one input side (2) and at least one output side (3) of the transformer are defined, wherein an input voltage $U_{in}$ can be applied to the input side (2) for the purpose of transformation into an output voltage $U_{out}$ on the output side (3) in accordance with a transformation ratio $\frac{U_{out}}{U_{in}} = K_u$, and wherein the piezoelectric element (1) has a plurality of plies (4a, 4b, 4c) of internal electrodes which are arranged in a direction perpendicular in relation to the direction of the length dimension in a plurality of different layers (S1, S2, S3), wherein each ply (4a, 4b, 4c) of internal electrodes extends along at least one predetermined subsection of the length dimension, and wherein the subsections of plies (4a, 4c) of a first group of layers (S1, S3) and the subsections of plies (4b) of a second group of layers (S2) have different dimensions, so that the piezoelectric transformer satisfies the following condition:

$$C_{in} \leq N^2 C_{out},$$

where $C_{in}$ denotes the input capacitance, $C_{out}$ denotes the output capacitance and N denotes the transformation ratio of the ideal transformer, **characterized in that** the plies (4a, 4c) of internal electrodes of the first group of layers (S1, S3) each extend between a first and a second position (P1, P2) in a range of > 0 and $\leq \frac{1}{2}L$ of the length dimension and the respective subsection between the first and the second position (P1, P2) assumes a length of $\leq \frac{1}{4}L$ of the length dimension.

2. Piezoelectric transformer according to Claim 1, wherein layers (S1, S3) of the first group alternate with layers (S2) of the second group.

3. Piezoelectric transformer according to Claim 1 or 2, wherein the plies (4a, 4c) of internal electrodes of the first group of layers (S1, S3) each extend between the first and the second position (P1, P2) symmetrically around the position at $\frac{1}{4}L$ of the length dimension.

4. Piezoelectric transformer according to one of Claims 1 to 3, wherein the plies (4b) of internal electrodes of the second group of layers (S2) each extend between a first and a second position (P1, P2) in a range of > 0 and $\leq \frac{1}{2}L$ of the length dimension and the respective subsection between the first and the second position (P1, P2) assumes a length of $> \frac{1}{4}L$ and $< \frac{1}{2}L$ of the length dimension.

5. Piezoelectric transformer according to one of Claims 1 to 3, wherein the plies (4b) of internal electrodes of the second group of layers (S2) each extend between a first and a second position (P1, P2) in a range of > 0 and $\leq \frac{3}{4}L$ of the length dimension and the respective subsection between the first and the second position (P1, P2) assumes a length of $\geq \frac{3}{8}L$ and $< \frac{3}{4}L$ of the length dimension.

6.  Piezoelectric transformer according to Claim 4 or 5, wherein the plies (4b) of internal electrodes of the second group of layers (S2) each additionally extend in a subsection between a third and a fourth position (P3, P4) in a range of $\geq \frac{7}{8}L$ and $\leq L$ of the length dimension.

7.  Piezoelectric transformer according to one of Claims 4 to 6, wherein, with respect to the length dimension, the first position (P1) of the plies (4b) of internal electrodes of the second group of layers (S2) corresponds to the first position (P1) of the plies (4a, 4c) of internal electrodes of the first group of layers (S1, S3).

8.  Piezoelectric transformer according to one of Claims 1 to 7, wherein the piezoelectric element (1) is polarized in a direction perpendicular in relation to the direction of the longitudinal dimension on the input side (2) and is polarized in the direction of the length dimension on the output side (3).

9.  Piezoelectric transformer according to one of Claims 1 to 8, wherein the input side (2) is set in the range of from 0 to $\frac{1}{2}L$ of the length dimension of the piezoelectric element (1) and the output side (3) is set in the range of from $\frac{1}{2}L$ to $L$ of the length dimension of the piezoelectric element (1).

**Revendications**

1.  Transformateur piézoélectrique comprenant un élément piézoélectrique (1) doté d'une dimension longitudinale prédéterminée de longueur $L$, le long de laquelle au moins un côté d'entrée (2) et au moins un côté de sortie (3) du transformateur sont définis, dans lequel une tension d'entrée $U_{in}$ est applicable au côté d'entrée (2) pour transformation en une tension de sortie $U_{out}$ sur le côté de sortie (3) selon un rapport de transformation $U_{out}/U_{in} = K_u$, et dans lequel l'élément piézoélectrique (1) comporte plusieurs épaisseurs (4a, 4b, 4c) d'électrodes internes, lesquelles sont agencées en plusieurs couches différentes (S1, S2, S3) dans une direction perpendiculaire à la direction de la dimension longitudinale, dans lequel chaque épaisseur (4a, 4b, 4c) d'électrodes internes s'étend le long d'au moins une section prédéterminée de la dimension longitudinale et dans lequel les sections d'épaisseurs (4a, 4c) d'un premier groupe de couches (S1, S3) et les sections d'épaisseurs (4b) d'un deuxième groupe de couches (S2) possèdent des dimensions différentes, de sorte que le transformateur piézoélectrique remplit la condition :

$$C_{in} \leq N^2 C_{out}$$

dans lequel $C_{in}$ désigne la capacité d'entrée, $C_{out}$ la capacité de sortie et N le rapport de transformation du transformateur idéal, **caractérisé en ce que** les épaisseurs (4a, 4c) d'électrodes internes du premier groupe de couches (S1, S3) s'étendent respectivement entre une première et une deuxième position (P1, P2) dans un intervalle > 0 et $\leq \frac{1}{2}L$ de la dimension longitudinale et la section respective occupe entre la première et la deuxième position (P1, P2) une longueur de $\leq \frac{1}{4}L$ de la dimension longitudinale.

2.  Transformateur piézoélectrique selon la revendication 1, dans lequel des couches (S1, S3) du premier groupe alternent avec des couches (S2) du deuxième groupe.

3.  Transformateur piézoélectrique selon la revendication 1 ou 2, dans lequel les épaisseurs (4a, 4c) d'électrodes internes du premier groupe de couches (S1, S3) s'étendent respectivement entre la première et la deuxième position (P1, P2) de manière symétrique autour de la position sur $\frac{1}{4}L$ de la dimension longitudinale.

4.  Transformateur piézoélectrique selon l'une des revendications 1 à 3, dans lequel les épaisseurs (4b) d'électrodes internes du deuxième groupe de couches (S2) s'étendent respectivement entre une première et une deuxième position (P1, P2) dans un intervalle >0 et $\leq \frac{1}{2}L$ de la dimension longitudinale et la section respective occupe entre la première et la deuxième position (P1, P2) une longueur de > $\frac{1}{4}L$ et < $\frac{1}{2}L$ de la dimension longitudinale.

**5.** Transformateur piézoélectrique selon l'une des revendications 1 à 3, dans lequel les épaisseurs (4b) d'électrodes internes du deuxième groupe de couches (S2) s'étendent respectivement entre une première et une deuxième position (P1, P2) dans un intervalle > 0 et ≤ ¾$L$ de la dimension longitudinale et la section respective occupe entre la première et la deuxième position (P1, P2) une longueur de ≥ ⅜$L$ et < ¾$L$ de la dimension longitudinale.

**6.** Transformateur piézoélectrique selon la revendication 4 ou 5, dans lequel les épaisseurs (4b) d'électrodes internes du premier groupe de couches (S2) s'étendent en outre respectivement dans une section entre une troisième et une quatrième position (P3, P4) dans un intervalle ≥ ⅞$L$ et ≤ $L$ de la dimension longitudinale.

**7.** Transformateur piézoélectrique selon l'une des revendications 4 à 6, dans lequel par rapport à la dimension longitudinale la première position (P1) des épaisseurs (4b) d'électrodes internes du deuxième groupe de couches (S2) correspond à la première position (P1) des épaisseurs (4a, 4c) d'électrodes internes du premier groupe de couches (S1, S3).

**8.** Transformateur piézoélectrique selon l'une des revendications 1 à 7, dans lequel l'élément piézoélectrique (1) est polarisé sur le côté d'entrée (2) dans une direction perpendiculaire à la direction de la dimension longitudinale et est polarisé sur le côté de sortie (3) dans la direction de la dimension longitudinale.

**9.** Transformateur piézoélectrique selon l'une des revendications 1 à 8, dans lequel le côté d'entrée (2) est disposé dans l'intervalle de 0 à ½$L$ de la dimension longitudinale de l'élément piézoélectrique (1) et le côté de sortie (3) est disposé dans l'intervalle de ½$L$ à $L$ de la dimension longitudinale de l'élément piézoélectrique (1).

# FIG 1 Stand der Technik

# FIG 2 Stand der Technik

## FIG 3

## FIG 4

## FIG 5   Stand der Technik

**IN DER BESCHREIBUNG AUFGEFÜHRTE DOKUMENTE**

**In der Beschreibung aufgeführte Patentdokumente**

- KR 20050000886 A
- JP 2002217467 A